# EUROPÄISCHE PATENTANMELDUNG

(11) **EP 3 627 570 A1**
(43) Veröffentlichungstag der Anmeldung: **25.03.2020**
(21) Anmeldenummer: 18195186.4
(22) Anmeldetag: 18.09.2018
(51) Int. Cl.: H01L 33/64

(54) **WÄRMETAUSCHER FÜR HALBLEITERBAUELEMENTE**

(71) Anmelder: Heraeus Additive Manufacturing GmbH, 63450 Hanau (DE)
(72) Erfinder: Fischer, Jakob, 64380 Roßdorf (DE); Klosch-Trageser, Michael, 63579 Freigericht (DE); Desgronte, Janek, 60314 Frankfurt (DE)
(74) Vertreter: Maiwald Patent- und Rechtsanwaltsgesellschaft mbH

(57) **Zusammenfassung**

Die vorliegende Erfindung betrifft einen Wärmetauscher, umfassend einen Wärmeaustauschbereich, wobei mindestens ein Sensor in den Wärmetauscher eingebettet ist.

## Beschreibung

Die vorliegende Erfindung betrifft einen Wärmetauscher, insbesondere für die Temperierung (z.B. Kühlung) von Halbleiterbauelementen, sowie ein Verfahren zu dessen Herstellung.

Vorrichtungen, die Halbleiterbauelemente wie z.B. LEDs enthalten, müssen in einem geeigneten Temperaturbereich gehalten werden (z.B. durch Kühlung). Insbesondere im Bereich der Hochleistungselektronik ist ein effizientes Thermomanagement von großer Bedeutung, um eine möglichst lange Lebensdauer der Halbleiterbauelemente zu gewährleisten. Die Relevanz einer effizienten Kühlung oder Temperierung wird beispielsweise von J. Harpain, elektronikJournal 03/2012, S. 18-20; M. Scheubeck, elektronikJournal 03/2012, S. 14-17; A. Weiss, productronic, 12, 2007, S. 62-63; A. Veitl, Elektronik, 15, 2010, S. 32-35 und in DE 10 2015 115 132 A1 beschrieben.

Die Abführung der von Halbleiterbauelementen erzeugten Wärme wird beispielsweise durch Kühlkörper unterstützt. Ein solcher Kühlkörper enthält typischerweise einen Wärmeaustauschbereich, in dem Spalten, Kanäle oder Hohlräume für die Zirkulation eines gasförmigen (z.B. Luft) oder flüssigen Kühlmediums vorliegen. Der Wärmeaustauschbereich wird durch voneinander beabstandete Flächenelemente wie Lamellen, Rippen oder Stiften gebildet.

Kühlkörper können mit passiver oder aktiver Kühlung arbeiten. Im Falle der aktiven Kühlung unterstützt ein Lüfter die Luftzirkulation und/oder weist der Wärmeaustauschbereich Hohlräume auf, in denen eine Kühlflüssigkeit zirkulieren kann.

Wärmetauscher, insbesondere Kühlkörper, werden aus Materialien mit hoher Wärmeleitfähigkeit, insbesondere Metallen wie Kupfer oder Kupferlegierungen und Aluminium oder Aluminiumlegierungen oder geeigneten Keramikmaterialien gefertigt. Die Herstellung erfolgt beispielsweise über konventionelle Herstellungsverfahren wie Strangguss, Strangpressen, Spritzguss, Drehen, Fräsen oder Schmieden. Mit diesen Herstellungsverfahren sind jedoch Wärmeaustauschbereiche mit komplexer Geometrie und/oder sehr feinen Abmessungen oder Kühlkörper, die als einstückige bzw. monolithische Einheit vorliegen, nicht oder nur sehr erschwert zugänglich.

Die Herstellung von Kühlkörpern über eine additive Fertigung (beispielsweise ein selektives Laserschmelzen) ist bekannt, siehe z.B. M. Wong et al., Rapid Prototyping Journal, 13, 2007, S. 291-297 und WO 2010/005501 A2. Über die additive Fertigung sind Wärmeaustauschbereiche mit komplexer Struktur zugänglich und es lassen sich einstückige, d.h. als monolithische Einheit vorliegende Kühlkörper fertigen.

Weiterhin ist bekannt, während der Herstellung eines Formkörpers über eine additive Fertigung funktionale Komponenten in diesen Formkörper einzubetten. WO 2012/175209 A1 beschreibt ein Verfahren, bei dem ein Teil einer Gehäusestruktur über ein additives Herstellungsverfahren wie z.B. ein selektives Lasersintern hergestellt wird, ein Aktor- und/oder Sensorelement in oder an der Gehäusestruktur angebracht wird und anschließend die additive Fertigung der Gehäusestruktur fortgesetzt wird, so dass die Gehäusestruktur das Aktor- und/oder Sensorelement zumindest teilweise umschließt. WO 2016/146374 A1 beschreibt ein Verfahren, bei dem ein Kanäle enthaltender Formkörper über ein additives Verfahren (z.B. ein pulverbettbasiertes Verfahren wie selektives Laserstrahlschmelzen oder Elektronenstrahlschmelzen) hergestellt wird und die Kanäle mit einem fließfähigen funktionalen (z.B. elektrisch leitfähigen) Material befüllt werden. Während der additiven Fertigung kann auch ein Sensor in den Formkörper integriert werden.

Weiterhin ist bekannt, in Halbleitervorrichtungen noch einen Temperatursensor anzubringen. DE 10 2012 013 466 A1 beschreibt eine Vorrichtung, in der ein Temperatursensor auf einer Leiterplatte angebracht ist und die Leiterplatte über ein Halteelement mit einem Kühlkörper verbunden ist. DE 10 2017 004 469 A1 beschreibt eine Vorrichtung, die neben dem Kühlkörper noch einen Temperatursensor aufweist, wobei das Sensorsignal des Temperatursensors einer Recheneinheit zugeführt wird, die in Abhängigkeit von dem Sensorsignal die Drehzahl des Lüfters reguliert.

Halbleitervorrichtungen enthalten häufig Bereiche, in denen mehrere Halbleiterbauelemente benachbart zueinander vorliegen (eine Anordnung bzw. ein Array von mehreren Halbleiterbauelementen, z.B. ein LED-Array). Die LEDs eines LED-Array können sich im Betrieb unterschiedlich stark erhitzen. Bei den bisher verwendeten Kühlkörpern, insbesondere LED-Kühlkörpern, wird die Temperatur üblicherweise seitlich vom Kühlkörper gemessen. Mit einem seitlich am Kühlkörper angebrachten Sensor lässt sich nur die Temperatur der äußeren Halbleiterbauelemente des Array bestimmen. Beispielsweise kann es sein, dass sich in einer Anordung von mehreren LEDs eine LED stärker erhitzt als andere, wodurch es zum Ausfall dieser LED kommen kann. Die ausfallende LED kann wiederum benachbarte LEDs durch die Erhitzung beschädigen. Letztendlich kann das gesamte LED-Array zerstört werden. Bei ungünstiger Positionierung des Temperatursensors wird die lokale Überhitzung einer ersten LED nicht oder nur verzögert erkannt.

Eine Aufgabe der vorliegenden Erfindung ist die Bereitstellung einer Vorrichtung, mit der sich eine Temperierung von Halbleiterbauelementen wie z.B. LEDs, insbesondere einer Anordnung bzw. eines Array mehrerer Halbleiterbauelemente, besser kontrollieren lässt.

Gelöst wird die Aufgabe durch einen Wärmetauscher, umfassend einen Wärmeaustauschbereich, wobei mindestens ein Sensor zumindest teilweise in den Wärmetauscher eingebettet ist.

Der Sensor ist bevorzugt ein Temperatursensor. Im Rahmen der vorliegenden Erfindung ist es aber auch möglich, dass der Sensor ein Drucksensor, ein Strömungssensor, ein Dehnungssensor, ein Beschleunigungssensor oder ein pH-Sensor ist. Mit einem Dehnungssensor kann beispielsweise eine thermisch induzierte Spannung erfasst werden. Mit einem Beschleunigungssensor kann beispielsweise bei einer Verkippung des Wärmetauschers der Druck oder Volumenstrom der Fluidströmung angepasst werden.

Durch die Einbettung eines Sensors in den Wärmetauscher, auf dem wiederum beispielsweise eine Anordnung (Array) mehrerer Halbleiterbauelemente aufgebracht wird, werden der Sensor (insbesondere der Temperatursensor) und die Halbleiterbauelemente in eine größere räumliche Nähe zueinander gebracht. Da die Einbettung des Sensors prinzipiell an jeder Stelle des Wärmetauschers erfolgen kann, eröffnet dies im Fall eines Temperatursensors auch die Möglichkeit, in einem Array von Halbleiterbauelementen nicht nur die Temperatur der außen liegenden Halbleiterbauelemente, sondern auch die Temperatur derjenigen Halbleiterbauelemente, die "mittig" bzw. zentral in dem Array vorliegen, zu bestimmen.

Der Wärmeaustauschbereich enthält üblicherweise Spalten, Kanäle oder Hohlräume, in denen ein gasförmiges oder flüssiges Medium ("Temperiermedium") zirkulieren kann. Der Wärmeaustauschbereich wird beispielsweise durch voneinander beabstandete Lamellen, Rippen, Stifte oder sonstige voneinander beabstandete Flächenelemente gebildet. Die Spalten, Kanäle oder Hohlräume können offen oder geschlossen sein. Offene Spalten, Kanäle oder Hohlräume sind nicht vollständig von den beabstandeten Flächenelementen umschlossen, so dass das zirkulierende Temperiermedium aus den Spalten, Kanäle oder Hohlräume auch wieder entweichen kann. Geschlossene Spalten, Kanäle oder Hohlräume sind vollständig von den beabstandeten Flächenelementen umschlossen, so dass das zirkulierende Temperiermedium aus den Spalten, Kanäle oder Hohlräume nicht entweichen kann.

Wenn der Sensor ein Drucksensor, Strömungssensor oder pH-Sensor ist, kann damit beispielsweise die Funktionsfähigkeit des im Wärmetauscher zirkulierenden flüssigen oder gasförmigen Temperiermediums kontrolliert werden. Bei diesen Sensoren kann es bevorzugt sein, dass sie nur teilweise in den Wärmetauscher eingebettet, d.h. nicht vollständig von einem Material des Wärmetauschers umgeben sind, so dass ein Kontakt des Sensors mit dem zirkulierenden Temperiermedium möglich ist.

Der Wärmetauscher ist beispielsweise ein Kühlkörper.

Geeignete Materialien für die Herstellung eines Wärmetauschers, z.B. eines Kühlkörpers, sind dem Fachmann bekannt. Bevorzugt ist der Wärmeaustauschbereich des Wärmetauschers aus einem Metall und/oder einem keramischen Material hoher Wärmeleitfähigkeit gefertigt. Bevorzugt ist das Metall Kupfer oder Aluminium oder eine Legierung eines dieser Metalle. Ein bevorzugtes keramisches Material enthält beispielsweise ein Metalloxid wie Aluminiumoxid, Titanoxid oder Zirkonoxid oder ein Metallnitrid wie Aluminiumnitrid.

Um das Kontaktieren der zu temperierenden Halbleiterbauelemente (die z.B. in Form eines Array von mehreren Halbleiterbauelementen vorliegen) mit dem Wärmetauscher zu verbessern, kann der Wärmetauscher optional noch einen Basisbereich enthalten. Der Basisbereich weist eine Vorder- und eine Rückseite auf und auf der Rückseite liegt der Wärmeaustauschbereich vor, während auf der Vorderseite des Basisbereichs das Halbleiterbauelemente-Array (z.B. LED-Array) oder zunächst eine keramische Schicht und anschließend das Halbleiterbauelemente-Array angebracht werden können.

Beispielsweise liegt der Basisbereich in Form einer Platte vor. Die den Basisbereich des Kühlkörpers bildende Platte kann eben oder auch gekrümmt sein. Die Platte kann eine runde oder auch eine eckige Form aufweisen. Ist die Platte gekrümmt, kann sie auch in Form eines Zylinders vorliegen bzw. an komplexe Freiformgeometrien von Halbleiterelementen konturnah bzw. geometrienah angepasst sein. Die Dicke des Basisbereichs (z.B. der Platte) ist bevorzugt so gewählt, dass sich übliche Sensoren, insbesondere Temperatursensoren vollständig in diesen Basisbereich einbetten lassen, d.h. der Temperatursensor vollständig von dem den Basisbereich bildenden Material (beispielsweise ein Metall wie Cu, Al oder eine Legierung eines dieser Metalle oder ein keramisches Material) umschlossen ist. Beispielsweise weist der Basisbereich des Wärmetauschers eine Dicke von mindestens 3 mm, z.B. im Bereich von 3-20 mm oder 3-10 mm auf. Je nach Größe bzw. Fläche des zu kühlenden Halbleiterbauelemente-Arrays können Länge und Breite des Basisbereichs über einen breiten Bereich variieren. Beispielsweise weist der Basisbereich eine Länge im Bereich von 20-500 mm und eine Breite im Bereich von 20-500 mm auf.

Hinsichtlich geeigneter Materialien für den Basisbereich kann auf die oben bereits erwähnten Materialien des Wärmeaustauschbereichs verwiesen werden. Bevorzugt ist der Basisbereich des Wärmetauschers daher aus einem Metall und/oder einem keramischen Material hoher Wärmeleitfähigkeit gefertigt. Bevorzugt ist das Metall Kupfer oder Aluminium oder eine Legierung eines dieser Metalle. Ein bevorzugtes keramisches Material enthält beispielsweise ein Metalloxid wie Aluminiumoxid, Titanoxid oder Zirkonoxid oder ein Metallnitrid wie Aluminiumnitrid. Sofern der Sensor teilweise oder vollständig in den Basisbereich des Wärmetauschers eingebettet ist, umschließt das den Basisbereich bildende Material teilweise oder vollständig den Sensor.

Wie nachfolgend noch eingehender beschrieben wird, ist es bevorzugt, dass die Herstellung des Wärmeaustauschbereichs und, sofern vorhanden, des Basisbereichs zumindest teilweise über eine additive Fertigung (wie z.B. ein selektives Laser- oder Elektronenstrahlschmelzen) erfolgt. Dies ermöglicht, dass der Wärmeaustauschbereich und der optionale Basisbereich einstückig (d.h. monolithisch) ausgebildet werden. Auch ermöglicht die additive Fertigung die Ausbildung einer stoffschlüssigen Verbindung zwischen dem Sensor und dem ihn teilweise oder vollständig umgebenden Materials des Wärmetauschers (insbesondere des Basisbereichs oder des Wärmeaustauschbereichs).

In einer bevorzugten Ausführungsform liegen daher der Wärmeaustauschbereich und der optionale Basisbereich des Wärmetauschers einstückig, d.h. als monolithische Einheit vor.

Wie oben ausgeführt, ist mindestens ein Sensor, z.B. ein Temperatursensor, zumindest teilweise in den Wärmetauscher (z.B. den Kühlkörper) eingebettet.

Der Sensor ist also zumindest teilweise oder sogar vollständig von einem Material des Wärmetauschers, insbesondere dem den Basisbereich oder den Wärmeaustauschbereich bildenden Material (z.B. Kupfer oder Aluminium oder eine Legierung eines dieser Metalle oder ein keramisches Material) umschlossen.

Im Rahmen der vorliegenden Erfindung ist es möglich, dass nur ein Sensor in den Wärmetauscher eingebettet ist. Um eine ortsaufgelöste Information über die Temperatur in dem Array der Halbleiterbauelemente zu erhalten, kann es bevorzugt sein, zwei oder mehr Temperatursensoren in den Wärmetauscher einzubetten.

Sofern der Wärmetauscher keinen Basisbereich aufweist, ist der Sensor bevorzugt in den Wärmeaustauschbereich eingebettet.

Sofern der Wärmetauscher zusätzlich zu dem Wärmeaustauschbereich noch einen Basisbereich aufweist, kann der Sensor alternativ auch in den Basisbereich eingebettet sein. Im Rahmen der vorliegenden Erfindung ist es auch möglich, dass sowohl in den Wärmeaustauschbereich wie auch in den Basisbereich des Wärmetauschers mindestens ein Sensor eingebettet ist.

Wie oben bereits erwähnt, kann auf der Vorderseite des Basisbereichs entweder direkt das Halbleiterbauelemente-Array (z.B. LED-Array) oder zunächst eine keramische Schicht und anschließend das Halbleiterbauelemente-Array angebracht werden. Um eine möglichst zuverlässige Temperaturbestimmung der Halbleiterbauelemente zu ermöglichen, kann es bevorzugt sein, den Temperatursensor so in den Basisbereich einzubetten, dass er einerseits zwar noch vollständig von dem Bereich des Basismaterials umschlossen ist, andererseits aber einen möglichst geringen Abstand zu der Vorderseite des Basisbereichs aufweist. In einer bevorzugten Ausführungsform ist der Temperatursensor so in den Basisbereich eingebettet, dass er vollständig von dem den Basisbereich bildenden Material umschlossen ist, wobei der Abstand des eingebetteten Temperatursensors von der Vorderseite des Basisbereichs maximal 1000 µm, bevorzugter maximal 500 µm, z.B. 100-1000 µm oder 100-500 µm beträgt.

Der Temperatursensor und das ihn umgebende Material des Wärmeaustauschbereichs und/oder des Basisbereichs sind in thermischem Kontakt miteinander, d.h. sie sind nicht thermisch isoliert voneinander, sondern thermisch leitend miteinander verbunden.

Geeignete Temperatursensoren sind dem Fachmann bekannt. Der Temperatursensor ist beispielsweise ein Thermistor (z.B. ein Heißleiter oder ein Kaltleiter) oder ein Thermoelement. Optional ist der Sensor mit einer elektrischen Verdrahtung versehen.

Sofern der Temperatursensor in ein Metall (z.B. das den Basisbereich oder den Wärmeaustauschbereich bildende Metall) eingebettet ist und der eingebettete Temperatursensor ein Thermoelement ist, wird das Thermoelement mit einer elektrisch isolierenden Beschichtung versehen.

Optional kann der Sensor eine Einhausung, Ummantelung oder Beschichtung aufweisen.

Optional ist der Sensor bzw. jeder der Sensoren mit einer Recheneinheit verbunden, über die eine Auswertung der Messsignale erfolgen kann. Dies kann über eine feste Verdrahtung oder auch drahtlos realisiert sein.

Bevorzugt ist der Sensor bzw. jeder der Sensoren stoffschlüssig in den Wärmetauscher (z.B. in den Basisbereich oder den Wärmeaustauschbereich des Wärmetauschers) eingebettet, d.h. zwischen dem Temperatursensor und dem ihn umgebenden Material des Wärmetauschers, insbesondere des Basis- oder des Wärmeaustauschbereichs, liegt eine stoffschlüssige Verbindung vor. Wie dem Fachmann bekannt ist, handelt es sich bei stoffschlüssigen Verbindungen zwischen zwei Komponenten bzw. Bauteilen um solche Verbindungen, die nicht mehr lösbar sind. Eine Trennung stoffschlüssig miteinander verbundener Bauteile ist nur durch Zerstörung der Verbindung möglich. Eine geeignete Auswahl von Materialien, die stoffschlüssige Verbindungen ausbilden können (z.B. bei geeigneter thermischer Behandlung), kann der Fachmann aufgrund seines Fachwissens vornehmen. Um die Ausbildung einer stoffschlüssigen Verbindung mit dem umgebenden Material zu optimieren, kann der Sensor optional mit einer Beschichtung versehen werden.

Sofern der Temperatursensor in ein Metall (z.B. das den Basisbereich oder den Wärmeaustauschbereich bildende Metall) eingebettet ist, kann es beispielsweise bevorzugt sein, dass der Temperatursensor eine Beschichtung, Einhausung oder Ummantelung aus einem Metall aufweist, das mit dem umgebenden Metall eine Legierung ausbilden kann.

Optional kann die additiv gefertigte Oberflächenstruktur hinsichtlich einer besseren Benetzbarkeit für die Realisierung der stoffschlüssigen Verbindung durch eine angepasste Prozessführung des additiven Fertigungsprozesses beeinflusst werden. Ferner kann eine Dehnungstruktur, die zur Minimierung für thermisch induzierte Spannungen zwischen Sensor und Umhausung/gedruckter Struktur im Einbettbereich beiträgt, erzeugt werden. Solche Strukturen können bespielsweise geometrisch definierte Gitterstrukturen oder geometrisch undefinierte poröse schaumartige Segmente darstellen. Die Herstellung solcher Strukturen oder Bereiche mittels additiver Fertigung ist dem Fachmann bekannt.

Optional enthält der Wärmetauscher eine keramische Schicht. Diese keramische Schicht ist beispielsweise auf dem Wärmeaustauschbereich und/oder, sofern vorhanden, auf dem Basisbereich des Wärmetauschers aufgebracht. In einer bevorzugten Ausführungsform enthält der Wärmetauscher einen Basisbereich, der eine Vorder- und eine Rückseite aufweist, und auf der Rückseite der Wärmeaustauschbereich vorliegt, während auf der Vorderseite des Basisbereichs die keramische Schicht angebracht ist. Wärmeaustauschbereich und keramische Schicht liegen also auf gegenüberliegenden Seiten des Basisbereichs vor. Die keramische Schicht kann ein- oder mehrlagig sein. Die keramische Schicht wird beispielsweise durch eine Oxid-Keramik (z.B. ein Metalloxid wie Aluminiumoxid, Titanoxid oder Zirkonoxid) oder eine Nitrid-Keramik (z.B. ein Metallnitrid wie Aluminiumnitrid) gebildet. Die Dicke der keramischen Schicht kann in Abhängigkeit von den aufzubringenden Bauelementen und der konkreten Anwendung über einen breiten Bereich variiert werden. Die Dicke der keramischen Schicht liegt beispielsweise im Bereich von 0,1 mm bis 1,5 mm, bevorzugter 0,4 mm bis 1,2 mm. Es können aber auch keramische Schichten mit geringerer Schichtdicke, z.B. im Bereich von 10 µm bis 100 µm verwendet werden. Die keramische Schicht kann beispielsweise durch additive Fertigung, eine nasschemische Abscheidung, Auflöten oder Aufkleben in dem Wärmetauscher, insbesondere auf der Vorderseite des Basisbereichs angebracht werden. Auf dieser keramischen Schicht können die Halbleiterbauelemente befestigt werden (z.B. durch Löten).

In einer bevorzugten Ausführungsform enthält der Wärmetauscher
- einen Wärmeaustauschbereich, der aus einem Metall, insbesondere Kupfer, einer Kupferlegierung, Aluminium oder einer Aluminiumlegierung gefertigt ist,
- einen Basisbereich, der aus einem Metall, insbesondere Kupfer, einer Kupferlegierung, Aluminium oder einer Aluminiumlegierung, noch bevorzugter aus dem gleichen Metall wie der Wärmeaustauschbereich gefertigt ist, wobei der Basisbereich eine Vorder- und eine Rückseite aufweist, der Wärmeaustauschbereich auf der Rückseite des Basisbereichs vorliegt und der Basisbereich und der Wärmeaustauschbereich zusammen eine monolithische Einheit bilden,
- einen Temperatursensor, der in den Basisbereich eingebettet ist, wobei der Temperatursensor zumindest teilweise, bevorzugt vollständig von dem Metall des Basisbereichs umschlossen ist,
- eine keramische Schicht, die auf der Vorderseite des Basisbereichs vorliegt. Wie oben bereits erwähnt, kann es bevorzugt sein, dass der Abstand des vollständig eingebetteten Temperatursensors von der Vorderseite des Basisbereichs maximal 1000 µm, bevorzugter maximal 500 µm, z.B. 100-1000 µm oder 100-500 µm beträgt.

Alternativ kann es auch bevorzugt sein, dass sowohl der Basisbereich wie auch der Wärmeaustauschbereich aus einem keramischen Material gefertigt sind und der Temperatursensor in den keramischen Basisbereich eingebettet ist, wobei der Temperatursensor zumindest teilweise, bevorzugt vollständig von dem keramischen Material des Basisbereichs umschlossen ist. Optional kann auf der Vorderseite des Basisbereichs noch eine keramische Schicht vorliegen. Da der Basisbereich aber bereits aus einem keramischen Material gefertigt ist, kann auf eine solche zusätzliche keramische Schicht auch verzichtet werden. In diesem Fall kann das Array der Halbleiterelemente direkt auf der Vorderseite des keramischen Basisbereichs aufgebracht werden (z.B. durch Auflöten).

Die vorliegende Erfindung betrifft außerdem die Verwendung des oben beschriebenen Wärmetauschers als Kühlkörper zum Kühlen eines oder mehrerer Halbleiterbauelemente.

Das Halbleiterbauelement ist beispielsweise eine Diode, insbesondere eine Leuchtdiode ("LED") oder eine Fotodiode, ein Halbleiterlaser, ein Oberflächenemitter (VCSEL), ein Spannungswandler, ein Speicherchip (z.B. RAM-Speicher), eine CPU oder eine GPU.

In einer bevorzugten Ausführungsform wird der Kühlkörper zum Kühlen eines Array bzw. einer Anordnung mehrerer Halbleiterbauelemente (z.B. eines LED-Array) verwendet.

Die Kühlung der Halbleiterbauelemente kann passiv (d.h. ausschließlich durch freie Konvektion) oder alternativ auch aktiv (z.B. durch Verwendung einer im Wärmeaustauschbereich des Kühlkörpers zirkulierenden Kühlflüssigkeit oder durch Verwendung eines Ventilators) erfolgen.

Die vorliegende Erfindung betrifft außerdem eine Vorrichtung, umfassend den oben beschriebenen Wärmetauscher und ein oder mehrere Halbleiterbauelemente.

Hinsichtlich der Eigenschaften des Wärmetauschers sowie der Halbleiterbauelemente kann auf die oben gemachten Ausführungen verwiesen werden.

Wie oben bereits beschrieben, kann der Wärmetauscher optional einen Basisbereich aufweisen. Der Basisbereich des Wärmetauschers weist eine Vorderseite und eine gegenüberliegende Rückseite auf. Sind die Halbleiterbauelemente beispielsweise auf der Vorderseite des Basisbereichs angebracht, so liegt der Wärmeaustauschbereich auf der Rückseite des Basisbereichs vor.

Hinsichtlich der bevorzugten Eigenschaften des Basisbereichs und des Wärmeaustauschbereichs kann wiederum auf die oben gemachten Ausführungen verwiesen werden.

Wie oben bereits erwähnt, kann der Wärmetauscher eine keramische Schicht enthalten, die beispielsweise auf der Vorderseite des Basisbereichs vorliegt. Auf der keramischen Schicht sind die Halbleiterbauelemente (z.B. in Form eines Array) angebracht.

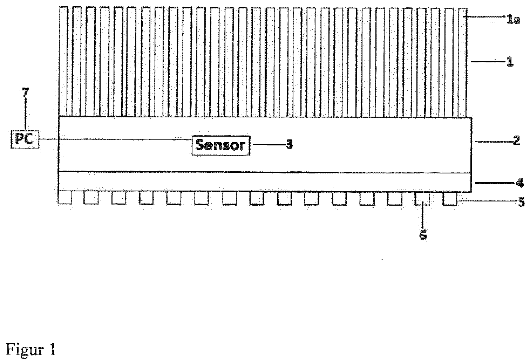

Eine beispielhafte Ausführungsform zeigt Figur 1.

Der Kühlkörper weist einen Wärmeaustauschbereich 1 und einen Basisbereich 2 auf. Bevorzugt sind beide Bereiche aus einem Metall (z.B. Kupfer oder Aluminium oder eine Legierung eines dieser Metalle) oder einem keramischen Material gefertigt. Über ein additives Fertigungsverfahren (z.B. selektives Laser- oder Elektronenstrahlschmelzen) lassen sich diese beiden Bereiche in Form einer monolithischen Einheit herstellen. Der Wärmeaustauschbereich 1 wird durch voneinander beabstandete Flächenelemente 1a gebildet. In den Zwischenräumen dieser Flächenelemente 1a kann ein flüssiges oder gasförmiges Kühlmedium (z.B. Luft) zirkulieren. Der Basisbereich 2 des Kühlkörpers liegt beispielsweise in Form einer Platte vor. In diesen plattenförmigen Basisbereich ist der Sensor 3 vollständig eingebettet (d.h. vollständig von dem Metall oder dem keramischen Material des Basisbereichs 2 umschlossen). Der Sensor 3 ist mit einer Recheneinheit 7 verbunden, über die eine Auswertung der Messsignale erfolgt. In der in Figur 1 gezeigten Ausführungsform ist der Sensor 3 so in den Basisbereich 2 eingebettet, dass die Temperatur der zentral im Array positionierten LEDs erfasst wird. Optional können noch weitere Sensoren 3 in den Basisbereich 2 des Kühlkörpers eingebettet sein, so dass eine ortsaufgelöste Temperaturbestimmung des LED-Array möglich ist. Auf einer Seite des Basisbereichs 2 liegt der Wärmeaustauschbereich 1 des Kühlkörpers in Form von beabstandeten Flächenelementen (z.B. Kühlrippen) 1a vor, während auf der gegenüberliegenden Seite des Basisbereichs 2 eine keramische Schicht 4 aufgebracht ist. Auf dieser keramischen Schicht 4 sind eine Vielzahl von LEDs 6 durch Lötkontakte aufgebracht. Die Vielzahl der aufgelöteten LEDs bilden das LED-Array 5. Bevorzugt werden sowohl der Basisbereich 2 wie auch der Wärmeaustauschbereich 1 über eine additive Fertigung hergestellt und bilden zusammen eine monolithische Einheit. Für das Anbringen des Sensors 3 wird die additive Fertigung unterbrochen und nach dem Anbringen des Sensors 3 wieder fortgesetzt.

In einer bevorzugten Ausführungsform enthält der Wärmetauscher der Vorrichtung
- einen Wärmeaustauschbereich, der aus einem Metall, insbesondere Kupfer, einer Kupferlegierung, Aluminium oder einer Aluminiumlegierung gefertigt ist,
- einen Basisbereich, der aus einem Metall, insbesondere Kupfer, einer Kupferlegierung, Aluminium oder einer Aluminiumlegierung, noch bevorzugter aus dem gleichen Metall wie der Wärmeaustauschbereich gefertigt ist, wobei der Basisbereich eine Vorder- und eine Rückseite aufweist, der Wärmeaustauschbereich auf der Rückseite des Basisbereichs vorliegt und der Basisbereich und der Wärmeaustauschbereich zusammen eine monolithische Einheit bilden,
- einen Temperatursensor, der in den Basisbereich eingebettet ist, wobei der Temperatursensor zumindest teilweise, bevorzugt vollständig von dem Metall des Basisbereichs umschlossen ist,
- eine keramische Schicht, die auf der Vorderseite des Basisbereichs vorliegt, und
die Vorrichtung enthält mehrere Halbleiterbauelemente (z.B. eine Anordnung mehrerer LEDs, d.h. ein LED-Array), die auf der keramischen Schicht angebracht sind.

Bevorzugt ist der in den Basisbereich eingebettete Temperatursensor unterhalb des Zentrums des Arrays der Halbleiterbauelemente positioniert.

Alternativ kann es auch bevorzugt sein, dass die Vorrichtung einen Wärmetauscher enthält, dessen Basisbereich und Wärmeaustauschbereich jeweils aus einem keramischen Material gefertigt sind und der Temperatursensor in den keramischen Basisbereich eingebettet ist, wobei der Temperatursensor zumindest teilweise, bevorzugt vollständig von dem keramischen Material des Basisbereichs umschlossen ist. Optional kann auf der Vorderseite des Basisbereichs noch eine keramische Schicht vorliegen, auf der mehrere Halbleiterbauelemente (d.h. ein Array von Halbleiterbauelementen) angebracht sind. Da der Basisbereich aber bereits aus einem keramischen Material gefertigt ist, kann auf eine solche zusätzliche keramische Schicht auch verzichtet werden. In diesem Fall kann das Array der Halbleiterelemente direkt auf der Vorderseite des keramischen Basisbereichs vorliegen.

Die vorliegende Erfindung betrifft außerdem ein Verfahren zur Herstellung des oben beschriebenen Wärmetauschers, wobei
- ein Teilstück des Wärmetauschers hergestellt wird,
- zumindest ein Sensor, bevorzugt ein Temperatursensor an diesem Teilstück angebracht wird,
- die Herstellung des Wärmetauschers fortgesetzt wird, bis der Temperatursensor zumindest teilweise in den Wärmetauscher eingebettet ist.

Bei dem Teilstück, das vor dem Anbringen des Temperatursensors hergestellt wird, kann es sich beispielsweise um ein Teilstück des Wärmeaustauschbereichs oder, sofern der Wärmetauscher einen Basisbereich enthält, um ein Teilstück dieses Basisbereichs handeln.

Bevorzugt enthält der Wärmetauscher einen Basisbereich und es wird ein Teilstück des Basisbereichs hergestellt und nach dem Anbringen des Temperatursensors an dem Teilstück wird die Herstellung des Basisbereichs fortgesetzt, bis der Temperatursensor zumindest teilweise in den Basisbereich eingebettet ist.

Die Herstellung des Teilstücks kann beispielsweise über eine additive Fertigung oder ein konventionelles Verfahren wie Strangguss, Strangpressen, Spritzguss, Drehen, Fräsen, Schmieden, galvanisches Abscheiden oder eine Kombination aus mindestens zwei dieser Verfahren erfolgen.

In einer bevorzugten Ausführungsform wird das Teilstück über eine additive Fertigung hergestellt.

Wie dem Fachmann bekannt ist, handelt es sich bei einer additiven Fertigung um ein Verfahren, bei dem ein Formkörper auf Basis digitaler 3D-Daten schichtweise aufgebaut wird. Im Rahmen der vorliegenden Erfindung kann die additive Fertigung beispielsweise über ein Pulver- oder Draht-basiertes Auftragsschweißen oder ein Pulverbett-basiertes Strahlschmelzen (z.B. ein Laser- oder Elektronenstrahlschmelzen) erfolgen.

Um den Temperatursensor besser an dem Teilstück anbringen zu können, kann es bevorzugt sein, dass das Teilstück eine oder mehrere Kavitäten (z.B. in Form von Vertiefungen oder Hohlräumen) aufweist, in die der Sensor oder die Sensoren gelegt werden können.

Die Kavitäten können bereits im additiven Fertigungsverfahren generiert werden. Alternativ ist es auch möglich, die Kavitäten in dem Teilstück durch Materialabtrag auszubilden.

Das Anbringen des Temperatursensors an dem Teilstück des Basisbereichs kann manuell oder auch automatisiert erfolgen.

Optional kann das Anbringen des Temperatursensors an dem Teilstück durch geeignete Maßnahmen unterstützt werden, so dass sich eine stoffschlüssige Verbindung zwischen dem Temperatursensor und dem Teilstück ausbildet. Beispielsweise kann der Temperatursensor mit dem Teilstück durch Kleben, Löten oder Sintern verbunden werden.

Optional kann das Teilstück auch Kavitäten aufweisen, in die die elektrische Verdrahtung des Sensors gelegt wird.

Nachdem der Temperatursensor an dem Teilstück angebracht wurde (z.B. durch Einlegen in die Kavität und/oder geeignete Behandlungsschritte wie Kleben, Sintern oder Löten zur Ausbildung einer stoffschlüssigen Verbindung), wird die Herstellung des Teilstücks fortgesetzt, bis der Temperatursensor zumindest teilweise, bevorzugt vollständig eingebettet ist.

Die Fortsetzung der Herstellung des Teilstücks erfolgt bevorzugt über eine additive Fertigung. Hinsichtlich geeigneter additiver Fertigungsverfahren kann auf die obigen Ausführungen verwiesen werden (z.B. ein Pulver- oder Draht-basiertes Auftragsschweißen oder ein Pulverbett-basiertes Strahlschmelzen). Um eine effektive stoffschlüssige Verbindung zwischen dem Temperatursensor und dem bei der additiven Fertigung eingesetzten Pulver zu realisieren, kann der Temperatursensor beispielsweise eine Einhausung, Ummantelung oder Beschichtung aus einem Material aufweisen, das gemeinsam mit der aufgebrachten Pulverschicht aufgeschmolzen wird. Eine geeignete Materialauswahl kann der Fachmann aufgrund seines allgemeinen Fachwissens vornehmen. Sofern der Temperatursensor in ein Metall eingebettet ist, kann es beispielsweise bevorzugt sein, dass der Temperatursensor eine Einhausung, Ummantelung oder Beschichtung aus einem Metall aufweist, das mit dem umgebenden Metall eine Legierung ausbilden kann.

Die Herstellung des Wärmeaustauschbereichs des Wärmetauschers kann beispielsweise vor der Herstellung des Teilstücks des Basisbereichs erfolgen. Bevorzugt werden sowohl der Wärmeaustauschbereich wie auch das Teilstück des Basisbereichs über eine additive Fertigung hergestellt, so dass der Wärmeaustauschbereich und das Teilstück des Basisbereichs zusammen eine monolithische Einheit bilden. Alternativ ist es auch möglich, dass die Herstellung des Wärmeaustauschbereichs erst nach der Fertigstellung des Basisbereichs erfolgt.

Optional kann noch eine keramische Schicht aufgebracht werden, z.B. auf dem Basisbereich und/oder dem Wärmeaustauschbereich des Wärmetauschers. Sofern die keramische Schicht auf dem Basisbereich aufgebracht wird, liegen die keramische Schicht und der Wärmeaustauschbereich auf gegenüberliegenden Seiten des Basisbereichs vor. Die keramische Schicht kann beispielsweise durch additive Fertigung, eine nasschemische Abscheidung, Auflöten oder Aufkleben in dem Wärmetauscher, insbesondere auf der Vorderseite des Basisbereichs angebracht werden.

Weiterhin betrifft die vorliegende Erfindung ein Verfahren zur Herstellung einer Vorrichtung, wobei
- der Wärmetauscher nach dem oben beschriebenen Verfahren hergestellt wird und
- mindestens ein Halbleiterbauelement, bevorzugt eine Anordnung mehrerer Halbleiterbauelemente, auf dem Wärmetauscher angebracht werden.

Das Anbringen der Halbleiterbauelemente auf dem Wärmetauscher, bevorzugt auf der Vorderseite des Basisbereichs oder der keramischen Schicht, kann beispielsweise durch ein thermisches Fügen, insbesondere ein Löten erfolgen.

Beim thermischen Fügen sollte die Temperatur nicht zu hoch sein, da ansonsten die Halbleiterbauelemente beschädigt werden könnten. Es kann daher bevorzugt sein, während des thermischen Fügens die Temperatur durch die Temperatursensoren messen zu lassen, um frühzeitig zu erkennen, ob an bestimmten Stellen des Halbleiter-Array eine kritische Temperatur überschritten wird. Bei einer Überschreitung eines vorgegebenen Temperaturgrenzwertes werden bevorzugt die Bedingungen des thermischen Fügens so abgeändert, dass die thermische Belastung reduziert und der Grenzwert wieder unterschritten wird.

## Patentansprüche

1. Ein Wärmetauscher, umfassend einen Wärmeaustauschbereich, wobei mindestens ein Sensor zumindest teilweise in den Wärmetauscher eingebettet ist.

2. Der Wärmetauscher nach Anspruch 1, wobei der Sensor ein Temperatursensor, ein Drucksensor, ein Strömungssensor, ein Dehnungssensor, ein Beschleunigungssensor oder ein pH-Sensor ist.

3. Der Wärmetauscher nach Anspruch 1 oder 2, außerdem enthaltend einen Basisbereich mit einer Vorder- und einer Rückseite, wobei der Wärmeaustauschbereich auf der Rückseite des Basisbereichs vorliegt.

4. Der Wärmetauscher nach einem der vorstehenden Ansprüche, wobei der Sensor in den Basisbereich oder den Wärmeaustauschbereich eingebettet ist; und/oder der Sensor stoffschlüssig eingebettet ist.

5. Der Wärmetauscher nach einem der vorstehenden Ansprüche, wobei der Basisbereich und der Wärmeaustauschbereich zusammen als monolithische Einheit vorliegen; und/oder wobei der Basisbereich und/oder der Wärmeaustauschbereich mindestens teilweise über eine additive Fertigung hergestellt sind.

6. Der Wärmetauscher nach einem der vorstehenden Ansprüche, wobei der Basisbereich und/oder der Wärmeaustauschbereich aus einem Metall, insbesondere Kupfer, Aluminium oder einer Legierung eines dieser Metalle, oder einem keramischen Material gefertigt sind.

7. Der Wärmetauscher nach einem der vorstehenden Ansprüche, wobei der Basisbereich in Form einer Platte vorliegt; und/oder der Wärmeaustauschbereich voneinander beabstandete Flächenelemente aufweist.

8. Der Wärmetauscher nach einem der vorstehenden Ansprüche, wobei der Temperatursensor so in den Basisbereich eingebettet, dass er vollständig von dem den Basisbereich bildenden Material umschlossen ist, wobei der Abstand des eingebetteten Temperatursensors von der Vorderseite des Basisbereichs bevorzugt maximal 1000 µm beträgt.

9. Der Wärmetauscher nach einem der vorstehenden Ansprüche, weiterhin enthaltend eine keramische Schicht, die auf dem Wärmeaustauschbereich oder der Vorderseite des Basisbereichs aufgebracht ist.

10. Verwendung des Wärmetauschers gemäß einem der Ansprüche 1-9 zum Temperieren eines oder mehrerer Halbleiterbauelemente, insbesondere einer Anordnung mehrerer Leuchtdioden.

11. Eine Vorrichtung, umfassend den Wärmetauscher nach einem der Ansprüche 1-9 und ein oder mehrere Halbleiterbauelemente.

12. Die Vorrichtung nach Anspruch 11, wobei der Wärmetauscher einen plattenförmigen Basisbereich enthält, auf der Rückseite des Basisbereichs der Wärmeaustauschbereich vorliegt und auf der Vorderseite des Basisbereichs optional eine keramische Schicht vorliegt, der Sensor stoffschlüssig in den Basisbereich eingebettet ist, und auf der Vorderseite des Basisbereichs oder, sofern vorhanden, auf der keramischen Schicht die Halbleiterbauelemente aufgebracht sind.

13. Ein Verfahren zur Herstellung des Wärmetauschers nach einem der Ansprüche 1-9, wobei
(i) ein Teilstück des Wärmetauschers hergestellt wird,
(ii) zumindest ein Sensor an diesem Teilstück angebracht wird,
(iii) die Herstellung des Teilstücks fortgesetzt wird, bis der Sensor zumindest teilweise in den Wärmetauscher eingebettet ist.

14. Das Verfahren nach Anspruch 13, wobei das Teilstück des Wärmetauschers ein Teilstück des Basisbereichs oder ein Teilstück des Wärmeaustauschbereichs ist; und/oder wobei zumindest die Herstellung des Teilstücks in Schritt (i), bevorzugt auch die Fortsetzung der Herstellung des Teilstücks in Schritt (iii) durch eine additive Fertigung erfolgt.

15. Ein Verfahren zur Herstellung der Vorrichtung gemäß Anspruch 11 oder 12, wobei
- der Wärmetauscher durch das Verfahren nach einem der Ansprüche 12-14 hergestellt wird und
- eine oder mehrere Halbleiterbauelemente auf dem Wärmetauscher angebracht werden.

16. Das Verfahren nach Anspruch 15, wobei das Anbringen der Halbleiterbauelemente auf dem Wärmetauscher durch ein thermisches Fügen, insbesondere ein Löten erfolgt.

17. Das Verfahren nach Anspruch 16, wobei während des thermischen Fügens eine Temperaturmessung durch den eingebetteten Temperatursensor erfolgt.
